(19) Europäisches Patentamt
European Patent Office
Office européen des brevets

(11) **EP 2 222 146 A1**

(12) **EUROPEAN PATENT APPLICATION**
published in accordance with Art. 153(4) EPC

(43) Date of publication:
**25.08.2010 Bulletin 2010/34**

(51) Int Cl.:
*H05K 1/14* (2006.01)     *C09J 7/00* (2006.01)
*C09J 9/02* (2006.01)     *C09J 11/04* (2006.01)
*C09J 201/00* (2006.01)     *H01B 5/16* (2006.01)
*H01R 11/01* (2006.01)     *H05K 3/36* (2006.01)

(21) Application number: **08861615.6**

(22) Date of filing: **16.12.2008**

(86) International application number:
**PCT/JP2008/072872**

(87) International publication number:
**WO 2009/078409 (25.06.2009 Gazette 2009/26)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **17.12.2007 JP 2007324619**

(71) Applicant: **Hitachi Chemical Company, Ltd.
Tokyo 163-0449 (JP)**

(72) Inventors:
• **TATSUZAWA, Takashi
Chikusei-shi
Ibaraki 308-8524 (JP)**
• **KOBAYASHI, Kouji
Chikusei-shi
Ibaraki 308-8524 (JP)**
• **ITO, Akihiro
Chikusei-shi
Ibaraki 308-8524 (JP)**

(74) Representative: **Albrecht, Thomas
Kraus & Weisert
Patent- und Rechtsanwälte
Thomas-Wimmer-Ring 15
80539 München (DE)**

(54) **CIRCUIT CONNECTING MATERIAL AND STRUCTURE FOR CONNECTING CIRCUIT MEMBER**

(57)     A circuit connecting material which is situated between mutually opposing circuit electrodes and, upon pressing the mutually opposing circuit electrodes, electrically connects the electrodes in the pressing direction, the circuit connecting material having a laminated construction comprising an anisotropic conductive adhesive layer A with conductive particles 21 dispersed therein and an insulating adhesive layer B, wherein the adhesive force of the insulating adhesive layer B for glass substrates is greater than the adhesive force of the anisotropic conductive adhesive layer A for glass substrates.

**Fig.2**

EP 2 222 146 A1

**Description**

**Technical Field**

The present invention relates to a circuit connecting material and a connected structure of a circuit member.

**Background Art**

Anisotropic conductive adhesive films, comprising conductive particles dispersed in circuit connecting materials that form electrical connections between electrodes in the direction of pressure when mutually opposing circuits are heated and pressed, such as epoxy-based adhesives or acrylic adhesives, for example, are widely used for electrical connection between liquid crystal display (LCD) panels and TCP (Tape Carrier Package) or COF (Chip On Flex) members on which are mounted mainly semiconductor chips that drive the LCDs, and between TCPs or COFs and printed circuit boards.

Recently, flip-chip mounting, which is advantageous for thickness reduction and narrow-pitch connection, has come to be employed instead of wire bonding methods even when semiconductors are mounted face-down directly on LCD panels or printed circuit boards, and anisotropic conductive adhesive films are used as circuit connecting materials for these as well (see Patent documents 1-4, for example).

With the employment of COFs and increasingly finer pitches in LCD modules in recent years, shorting between adjacent electrodes connected using circuit connecting materials is becoming a significant problem. One means that has been proposed to solve this problem is a technique for preventing electrical shorting by dispersion of insulating particles in the adhesive component (see Patent documents 5-9, for example).

Other techniques include adding silicone particles to the adhesive component that is used for bonding to wiring members whose boards are composed of insulating organic materials or glass, or wiring members having surfaces at least partially formed of silicon nitride, silicone resin and/or polyimide resin (Patent document 10, for example), and dispersing rubber particles in the adhesive to lower internal stress caused by differences in the coefficient of thermal expansion after bonding (Patent document 11, for example).

**Citation List**

[Patent document 1] Japanese Unexamined Patent Publication SHO No. 59-120436
[Patent document 2] Japanese Unexamined Patent Publication SHO No. 60-191228
[Patent document 3] Japanese Unexamined Patent Publication HEI No. 1-251787
[Patent document 4] Japanese Unexamined Patent Publication HEI No. 7-90237
[Patent document 5] Japanese Unexamined Patent Publication SHO No. 51-20941
[Patent document 6] Japanese Unexamined Patent Publication HEI No. 3-29207
[Patent document 7] Japanese Unexamined Patent Publication HEI No. 4-174980
[Patent document 8] Japanese Patent Publication No. 3048197
[Patent document 9] Japanese Patent Publication No. 3477367
[Patent document 10] International Patent Publication No. WO01/014484
[Patent document 11] Japanese Unexamined Patent Publication No. 2001-323249

**Summary of Invention**

Problems to be Solved by the Invention

With the aforementioned conventional circuit connecting materials, however, the flowing conductive particles pile up and aggregate due to protrusions in the organic film formed at the edges of the glass substrate, thus leading to electrical shorting. As a counter strategy, it is desirable to prevent shorting due to aggregation of conductive particles, by improving the entrapment efficiency for conductive particles on the electrode and reducing excess conductive particles.

In light of these circumstances, it is an object of the present invention to provide a circuit connecting material that has high entrapment efficiency for conductive particles on electrodes and excellent connection reliability, compared to conventional circuit connecting materials as well as a connected structure of a circuit member employing the sam e.

Means for Solving the Problems

The invention provides a circuit connecting material which is situated between mutually opposing circuit electrodes and, upon pressing the mutually opposing circuit electrodes, electrically connects the electrodes in the pressing direction, the circuit connecting material having a laminated construction of a conductive particle-dispersed anisotropic conductive adhesive layer and an insulating adhesive layer, wherein the adhesive force of the insulating adhesive layer for glass substrates is greater than the adhesive force of the anisotropic conductive adhesive layer for glass substrates.

This circuit connecting material has higher entrapment efficiency for conductive particles on electrodes and more excellent connection reliability, compared to conventional circuit connecting materials. The term "adhesive force" used throughout the present specification means force that can be measured by the following method, for example. Specifically, the adhesive sides of the anisotropic conductive adhesive layer and insulating adhesive layer are each transferred to an ITO-coated side of a fully ITO-coated glass substrate by heating and pressing at 70°C, 1 MPa for 2 seconds. The adhesive force is the force measurable when tape by Nitto Denko Corp. cut to a width of 2.5 mm is attached over the transferred adhesive, and the attached tape is peeled at 90° at a peel rate of 50 mm/min for each transferred adhesive.

The mean particle size a of the conductive particles and the thickness b of the anisotropic conductive adhesive layer preferably satisfy the relationship represented by the following formula (1): $a \geq b$ : (1).

The invention further provides a connected structure of a circuit member, comprising a first circuit member with a first connecting terminal and a second circuit member with a second connecting terminal, disposed with the first connecting terminal and second connecting terminal mutually opposing each other, wherein a circuit connecting material of the invention is situated between the mutually opposed first connecting terminal and second connecting terminal and the stack is heated and pressed to electrically connect the first connecting terminal and second connecting terminal.

Since this connected structure of a circuit member employs a circuit connecting material of the invention, it has higher entrapment efficiency for conductive particles on electrodes and more excellent connection reliability.

**Effect of the Invention**

According to the invention it is possible to provide a circuit connecting material that has high entrapment efficiency for conductive particles on electrodes and excellent connection reliability, compared to conventional circuit connecting materials as well as a connected structure of a circuit member employing the same.

**Brief Description of Drawings**

Fig. 1 is a cross-sectional process diagram schematically illustrating a method for producing a connected structure of a circuit member of an embodiment of the invention.
Fig. 2 is a schematic cross-sectional view showing an embodiment of a circuit connecting material of the invention.

Explanation of Symbols

1: Circuit connecting material, 2: circuit electrode, 3: LCD panel, 4: circuit board, 5: circuit board, 6: circuit electrode, 20: structure for connecting circuit member, 21: conductive particles, 22: resin, A: anisotropic conductive adhesive layer, B: insulating adhesive layer.

**Description of Embodiments**

Preferred embodiments of the invention will now be explained in detail, with reference to the accompanying drawings as necessary.

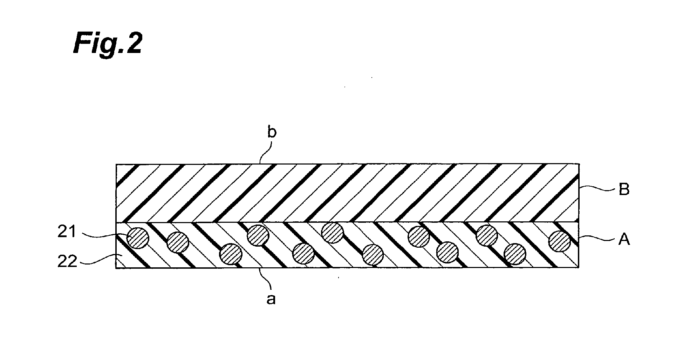

Fig. 2 is a schematic cross-sectional view showing an embodiment of a circuit connecting material of the invention. The circuit connecting material of this embodiment has a construction wherein an anisotropic conductive adhesive layer A with conductive particles 21 dispersed therein is laminated with an insulating adhesive layer B.

The conductive particles 21 may be metallic particles such as Au, Ag, Ni, Cu or solder, or carbon particles. The conductive particles 21 may also be particles consisting of nucleus particles covered with one or more layers, with a conductive outermost layer covering them. In this case, the outermost layer is preferably a precious metal such as Au, Ag or a platinum group rather than a transition metal such as Ni or Cu in order to obtain a sufficient pot life, and Au is more preferred.

The conductive particles 21 may also have the surface of a transition metal such as Ni covered with a precious metal such as Au. The conductive particles 21 may consist of insulating particles of nonconductive glass, ceramic or plastic covered with a conductive substance such as a metal. It is preferred for the conductive particles 21 to comprise insulating particles covered with a conductive substance with the outermost layer made of a precious metal and the insulating particle nuclei made of plastic, or for the conductive particles 21 to be heat-fusible metallic particles, in order to confer deformability by heat and pressure and to increase the contact area with the electrodes during connection for improved reliability.

The thickness of a precious metal covering layer is preferably at least 100 angstroms to obtain satisfactory resistance. However, when a precious metal covering layer is formed on a transition metal such as Ni, oxidation-reduction action produced by loss of the precious metal covering layer or loss of the precious metal covering layer caused by mixing and dispersion of the conductive particles, results in generation of free radicals and reduces the pot life, and therefore the thickness of the covering layer when using a radical polymerizing adhesive component is preferably at least 300 angstrom.

Although the conductive particles 21 will usually be added in a range of 0.1-30 parts by volume with respect to 100 parts by volume of the adhesive component, the preferred content will differ depending on the purpose. For example, the content is more preferably 0.1-10 parts by volume from the viewpoint of more thoroughly preventing shorting between adjacent circuits by the conductive particles 21.

The mean particle size of the conductive particles 21 is preferably 1-10 $\mu$m, more preferably 1-8 $\mu$m, even more preferably 2-6 $\mu$m, particularly preferably 3-5 $\mu$m and most preferably 3-4 $\mu$m, since limiting them to lower than the electrode heights of the circuits to be connected reduces shorting between adjacent electrodes. A material with a 10% compression modulus (K value) of 100-1000 kgf/mm$^2$ may be selected for use.

The mean particle size of the conductive particles can be determined in the following manner. Specifically, one nucleus particle is arbitrarily selected and observed with a differential scanning electron microscope to measure its maximum diameter and minimum diameter. The square root of the product of the maximum diameter and minimum diameter is recorded as the particle size of the particle. In this method, the particle sizes of 50 arbitrarily selected nucleus particles are measured and the average value is recorded as the mean particle size of the conductive particles.

The thickness of the anisotropic conductive adhesive layer A is preferably 1-5 $\mu$m and more preferably 1-4 $\mu$m, in order to minimize flow of the conductive particles 21.

The thickness of the insulating adhesive layer B is preferably 2-21 $\mu$m and more preferably 4-14 $\mu$m.

The ratio of the thickness of the anisotropic conductive adhesive layer A to the thickness of the insulating adhesive layer B is preferably 1:1-1:6 and more preferably 1:2-1:4. A ratio within this range will further improve the entrapment efficiency for the conductive particles 21 on the electrode.

In the circuit connecting material of this embodiment, the mean particle size a of the conductive particles 21 and the thickness b of the anisotropic conductive adhesive layer A preferably satisfy the relationship represented by the following formula (1):

$a \geq b$ : (1).

The thickness of the anisotropic conductive adhesive layer A is preferably a thickness of 20-100% and more preferably 25-75% with respect to the mean particle size of the conductive particles 21.

The ratio of the minimum melt viscosity of the anisotropic conductive adhesive layer A with respect to that of the insulating adhesive layer B is preferably at least 10. This will further improve the effect of inhibiting displacement of the conductive particles 21 during pressing. The upper limit for the minimum melt viscosity ratio is not particularly restricted but is preferably no greater than 1000, for example.

The circuit connecting material of the invention preferably comprises an adhesive composed of (a) an epoxy resin and (b) a latent curing agent, as the adhesive component in the anisotropic conductive adhesive layer A and insulating adhesive layer B.

As examples for the (a) epoxy resin there may be mentioned bisphenol-type epoxy resins derived from epichlorohydrin and bisphenol A, bisphenol F and/or bisphenol AD; epoxy-novolac resins derived from epichlorohydrin and phenol-novolac or cresol-novolac; naphthalene-based epoxy resins having naphthalene ring-containing backbones, and glycidylamine, glycidyl ether and epoxy compounds with two or more glycidyl groups in a biphenyl or alicyclic compound, and any of these may be used alone or in combinations of two or more. These epoxy resins are preferably high purity products with the impurity ion (Na$^+$, Cl$^-$, etc.) and hydrolyzable chlorine content reduced to below 300 ppm, in order to prevent electron migration.

For the (b) latent curing agent there may be mentioned imidazole-based, hydrazide-based, boron trifluoride-amine complex, sulfonium salt, amineimide, polyamine salt and dicyandiamide curing agents. They may also be used alone or in combinations of two or more, and may also be used in admixture with triggers or inhibitors. From the viewpoint of extending the usable life, these curing agents are preferably used in a microencapsulated form by coating with a polyurethane-based or polyester-based macromolecular compound.

The circuit connecting material of the invention preferably further comprises an adhesive composed of (c) a curing agent that generates free radicals upon heating or light exposure (hereunder also referred to as "free radical generator") and (d) a radical-polymerizing substance, as adhesive components in the anisotropic conductive adhesive layer A and insulating adhesive layer B.

The (c) free radical generator is a compound that generates free radicals upon decomposition by heating, such as a peroxide compound or azo-based compound, and it may be appropriately selected according to the target connection temperature, connection time and pot life, but from the viewpoint of high reactivity and pot life there are preferred organic peroxides with a 10-hour half-life temperature of 40°C or higher and a 1-minute half-life temperature of no higher than 180°C. In this case, the content of the (c) free radical generator is preferably 0.05-10 wt% and more preferably 0.1-5 wt% with respect to the total solid content of the adhesive.

The (c) free radical generator may be selected, specifically, from among diacyl peroxides, peroxy dicarbonates, peroxy esters, peroxy ketals, dialkyl peroxides and hydroperoxides. In order to minimize corrosion of the connecting terminals of the circuit members it is preferred to select a peroxy ester, dialkyl peroxide or hydroperoxide, and more preferably to select a peroxy ester which exhibits high reactivity.

As examples of diacyl peroxides there may be mentioned isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide.

As examples of peroxy dicarbonates there may be mentioned din-propylperoxy dicarbonate, diisopropylperoxy dicarbonate, bis(4-t-butylcyclohexyl)peroxy dicarbonate, di-2-ethoxymethoxyperoxy dicarbonate, di(2-ethylhexylperoxy) dicarbonate, dimethoxybutylperoxy dicarbonate and di(3-methyl-3-methoxybutylperoxy)dicarbonate.

As examples of peroxy esters there may be mentioned cumylperoxy neodecanoate, 1,1,3,3 -tetramethylbutylperoxy neodecanoate, 1-cyclohexyl-1-methylethylperoxy neodecanoate, t-hexylperoxy neodecanoate, t-butylperoxy pivalate, 1,1,3,3-tetramethylbutylperoxy-2-ethyl hexanonate, 2,5-dimethyl-2,5-bis(2-ethylhexanoylperoxy)hexane, 1-cyclohexyl-1-methylethylperoxy-2-ethyl hexanonate, t-hexylperoxy-2-ethyl hexanonate, t-butylperoxy-2-ethyl hexanonate, t-butylperoxy isobutyrate, 1,1-bis(t-butylperoxy)cyclohexane, t-hexylperoxyisopropyl monocarbonate, t-butylperoxy-3,5,5-trimethyl hexanonate, t-butylperoxy laurate, 2,5-dimethyl-2,5-bis(m-toluoylperoxy)hexane, t-butylperoxyisopropyl monocarbonate, t-butylperoxy-2-ethylhexyl monocarbonate, t-hexylperoxybenzoate and t-butylperoxy acetate.

As examples of peroxy ketals there may be mentioned 1,1-bis(t-hexylperoxy)-3,5,5-trimethylcyclohexane, 1,1-bis(t-hexylperoxy)cyclohexane, 1,1-bis(t-butylperoxy)-3,5,5-trimethylcyclohexane, 1,1-(t-butylperoxy)cyclododecane and 2,2-bis(t-butylperoxy)decane.

As examples of dialkyl peroxides there may be mentioned $\alpha,\alpha'$-bis(t-butylperoxy)diisopropylbenzene, dicumyl peroxide, 2,5-dimethyl-2,5-di(t-butylperoxy)hexane and t-butylcumyl peroxide.

As examples of hydroperoxides there may be mentioned diisopropylbenzene hydroperoxide and cumene hydroperoxide.

These (c) free radical generators may be used alone or in combinations of two or more, and may also be used in admixture with triggers or inhibitors and etc.

The (d) radical-polymerizing substance is a substance that has a functional group that polymerizes by radicals, and as specific examples there may be mentioned acrylates, methacrylates and maleimide compounds. The content of the (d) radical-polymerizing substance is preferably 25-55 wt% and more preferably 30-50 wt% with respect to the total solid content of the adhesive.

As examples of acrylates (or methacrylates) there may be mentioned urethane acrylate, methyl acrylate, ethyl acrylate, isopropyl acrylate, isobutyl acrylate, ethyleneglycol diacrylate, diethyleneglycol diacrylate, triethyleneglycol diacrylate, trimethylolpropane triacrylate, tetramethylolmethane tetraacrylate, 2-hydroxy-1,3-diacryloxypropane, 2,2-bis[4-(acryloxymethoxy)phenyl]propane, 2,2-bis[4-(acryloxypolyethoxy)phenyl]propane, dicyclopentenyl acrylate, tricyclodecanyl acrylate, bis(acryloxyethyl)isocyanurate, ε-caprolactone-modified tris(acryloxyethyl)isocyanurate and tris(acryloxyethyl)isocyanurate.

Preferred maleimide compounds are those containing two or more maleimide groups in the molecule, and as examples there may be mentioned 1-methyl-2,4-bismaleimidebenzene, N,N'-m-phenylenebismaleimide, N,N'-P-phenylenebismaleimide, N,N'-m-toluilenebismaleimide, N,N'-4,4-biphenylenebismaleimide, N,N'-4,4-(3,3'-dimethyl-biphenylene)bismaleimide, N,N'-4,4-(3,3'-dimethyldiphenylmethane)bismaleimide, N,N'-4,4-(3,3'-diethyldiphenylmethane) bismaleimide, N,N'-4,4-diphenylmethanebismaleimide, N,N'-4,4-diphenylpropanebismaleimide, N,N'-4,4-diphenyl etherbismaleimide, N,N'-3,3'-diphenylsulfonebismaleimide, 2,2-bis[4-(4-maleimidephenoxy)phenyl]propane, 2,2-bis[3-s-butyl-4,8-(4-maleimidephenoxy)phenyl]propane, 1,1-bis[4-(4-maleimidephenoxy)phenyl]decane, 4,4'-cyclohexylidene-bis[1-(4-maleimidephenoxy)-2-cyclohexyl]benzene and 2,2-bis[4-(4-maleimidephenoxy)phenyl]hexafluoropropane. These may be used alone or in combinations of two or more, and may also be used together with allyl compounds such as allylphenol, allylphenyl ether and allyl benzoate.

Any of these (d) radical-polymerizing substances may be used alone or in combinations of two or more. The (d) radical-polymerizing substance most preferably contains at least a radical-polymerizing substance with a 25°C viscosity of 100,000-1,000,000 mpa·s, and even more preferably contains a radical-polymerizing substance with a viscosity (25°C) of 100,000-500,000 mPa·s. The viscosity of the (d) radical-polymerizing substance may be measured using a commercially available E-type viscometer (Brookfield).

Urethane acrylate or urethane methacrylate is preferred among (d) radical-polymerizing substances from the viewpoint of adhesion, and most preferably it is used in combination with a radical-polymerizing substance that exhibits a Tg of 100°C or higher alone, after crosslinking with an organic peroxide used to improve the heat resistance. As such radical-polymerizing substances there may be used substances having dicyclopentenyl group, tricyclodecanyl group and/or triazine rings. Particularly preferred for use are radical-polymerizing substances with tricyclodecanyl groups and/or triazine rings in the molecule.

If necessary, an appropriate amount of a polymerization inhibitor such as hydroquinone or a methyl ether hydroquinone may be used in the circuit connecting material of the invention.

In addition, a radical-polymerizing substance having a phosphoric acid ester structure is preferably used at 0.1-10 wt%, and more preferably 0.5-5 wt%, to improve the bonding strength with inorganic material surfaces such as metals. The radical-polymerizing substance having a phosphoric acid ester structure is obtained as the reaction product of phosphoric anhydride and 2-hydroxyl (meth)acrylate. Specifically, there may be mentioned 2-methacryloyloxyethyl acid phosphate and 2-acryloyloxyethyl acid phosphate. These may be used alone or in combinations of two or more.

The circuit connecting material of this embodiment is preferably used in the form of a film for superior handleability, in which case it may contain a film-forming polymer. As film-forming polymers there may be mentioned polystyrene, polyethylene, polyvinyl butyral, polyvinyl formal, polyimides, polyamides, polyesters, polyvinyl chloride, polyphenylene oxide, urea resins, melamine resins, phenol resins, xylene resins, epoxy resins, polyisocyanate resins, phenoxy resins, polyimide resins, polyester-urethane resins and the like. Of these, resins with functional groups such as hydroxyl group are preferred since they can improve the adhesion. Such polymers that have been modified with radical-polymerizing functional groups may also be used. The weight-average molecular weight of such a polymer is preferably at least 10,000. A weight-average molecular weight of 1,000,000 or greater will lower the mixing property, and therefore it is preferably less than 1,000,000.

The circuit connecting material of this embodiment may also contain a filler, softening agent, accelerator, age inhibitor, coloring agent, flame retardant, thixotropic agent, coupling agent, phenol resin, melamine resin, isocyanate or the like.

A filler is preferably included in the circuit connecting material of this embodiment to improve the connection reliability. The filler used may be any one with a maximum diameter of less than the particle size of the conductive particles, and it is preferably used in a range of 5-60 vol%. The effect of improved reliability becomes saturated at greater than 60 vol%.

Preferred coupling agents, from the viewpoint of improving adhesion, are compounds containing one or more groups selected from among vinyl, acrylic, amino, epoxy and isocyanate groups.

In the circuit connecting material of the invention, the adhesive force of the adhesive side b of the insulating adhesive layer B for glass substrates is greater than the adhesive force of the adhesive side a of the anisotropic conductive adhesive layer A for glass substrates. The adhesive force of each layer can be adjusted by modifying the types or mixing ratio of the adhesive components.

A circuit connecting material having the construction of this embodiment also has an effect of improving pot life in addition to the effect of allowing conventional high definition, when it is separated into a layer containing a reactive resin and a layer containing a latent curing agent, or when it is separated into a layer containing a free radical-generating curing agent and a layer containing conductive particles.

The circuit connecting material of this embodiment is useful as a material for bonding between IC chips and boards, and bonding between electrical circuits. That is, it is possible to fabricate a connected structure of a circuit member by disposing a first circuit member with a first connecting terminal and a second circuit member with a second connecting terminal, in such a manner that the first connecting terminal and second connecting terminal are mutually opposing each other, and situating a circuit connecting material of the invention between the mutually opposed first connecting terminal and second connecting terminal and then heating and pressing the stack to electrically connect the first connecting terminal and second connecting terminal.

As examples of such connection structures for circuit members there may be mentioned chip parts such as semiconductor chips, resistor chips and condenser chips, and boards such as printed boards. A plurality of connecting terminals are usually provided on such connected structures of circuit members (although there may be a single one), with at least one pair of connected structures of circuit members being placed mutually opposing at least on parts of the connecting terminals provided on the connected structures of circuit members, and an adhesive is laid between the mutually opposing connecting terminals and the stack is heated and pressed to electrically connect the mutually opposing connecting terminals to form a circuit board. By heating and pressing at least one pair of connected structures of circuit members, it is possible to electrically connect the mutually opposing connecting terminals through the conductive particles in the anisotropic conductive adhesive (circuit connecting material).

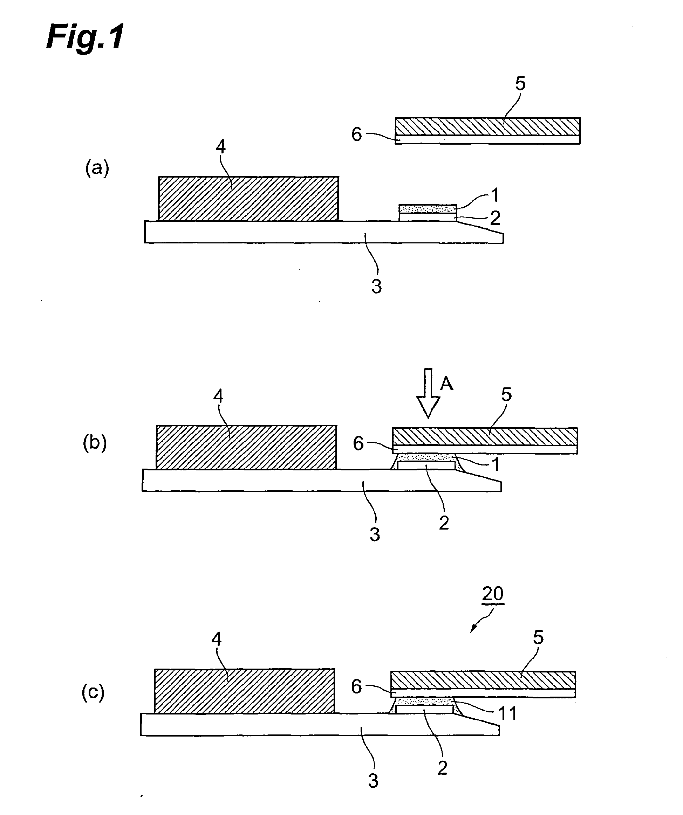

An embodiment of a method for producing a connected structure of a circuit member of the invention will now be explained. Fig. 1 is a cross-sectional process diagram schematically illustrating a method for producing a connected structure of a circuit member of an embodiment of the invention. Fig. 1(a) is a cross-sectional view of the circuit member before connection of the circuit members, Fig. 1(b) is a cross-sectional view of the connected structure of a circuit member during connection between the circuit members, and Fig. 1(c) is a cross-sectional view of the connected structure of a circuit member after connection of the circuit members.

First, as shown in Fig. 1(a), a film-like circuit connecting material 1 comprising a circuit connecting material molded into a film is placed on a circuit electrode 2 provided on a LCD panel 3.

Next, as shown in Fig. 1(b), a circuit board 5 having a circuit electrode 6 formed thereon is positioned on the film-like circuit connecting material 1 in such a manner that the circuit electrode 2 and circuit electrode 6 are mutually opposing, so that the film-like circuit connecting material 1 lies between the circuit electrode 2 and circuit electrode 6. The circuit electrodes 2 and 6 each have a structure with a plurality of electrodes arranged in the direction of depth (not shown).

The film-like circuit connecting material 1 is easy to manage since it is in the form of a film. The film-like circuit connecting material 1 can therefore be easily situated between the circuit electrode 2 and circuit electrode 6, thus facilitating the operation of connecting the LCD panel 3 and circuit board 5.

Next, the film-like circuit connecting material 1 lying between the LCD panel 3 and circuit board 5 is pressed in the directed of the arrow A in Fig. 1(b) while heating, for curing treatment. This yields a connected structure of a circuit member 20 having the circuit members connected together, as shown in Fig. 1(c). The method of curing treatment may be either or both heating and photoirradiation, depending on the adhesive composition used.

In the circuit connecting material of this embodiment, the adhesive that has flowed as a melt during connection to connect the opposing circuit electrodes is cured to maintain connection, and therefore the flow property of the adhesive is an important factor. When a 5 mm × 5 mm circuit connecting material with a thickness of 35 μm is sandwiched between 15 mm × 15 mm glass plates having a thickness of 0.7 mm, with hot pressing being carried out at 170°C, 2 MPa for 10 seconds, the value of the flow property (B)/(A), where (A) is the initial area on the main side of the adhesive and (B) is the area on the main side after hot pressing, is preferably 1.3-3.0 and more preferably 1.5-2.5. A value of less than 1.3 is a poor flow property which may not result in satisfactory connection, while a value of greater than 3.0 will tend to result in air bubble generation and inferior reliability.

The 40°C elastic modulus after curing of the circuit connecting material of this embodiment is preferably 100-3000 MPa and more preferably 500-2000 MPa.

In the method of connecting the circuit electrodes of this embodiment, a circuit connecting material that is curable by heat or light may be formed on one electrode circuit having on the surface at least one metal selected from among gold, silver, tin and platinum metals, and then another circuit electrode positioned thereover and heated and pressed therewith for connection.

Examples

The present invention will now be explained in greater detail through the following examples, with the understanding that these examples are in no way limitative on the invention.

[Synthesis of urethane acrylate A]

There were combined 400 parts by weight of polycaprolactonediol with a weight-average molecular weight of 800, 131 parts by weight of 2-hydroxypropyl acrylate, 0.5 part by weight of dibutyltin dilaurate as a catalyst and 1.0 part by weight of hydroquinonemonomethyl ether as a polymerization inhibitor, while stirring and heating at 50°C. Next, 222 parts by weight of isophorone diisocyanate was added dropwise and the temperature was raised to 80°C while stirring for urethanation reaction. Upon confirming at least a 99% isocyanate group reaction rate, the reaction temperature was lowered to obtain urethane acrylate A.

[Preparation of polyester-urethane resin]

Two different polyester-urethane resins, A and B, were prepared using terephthalic acid as a dicarboxylic acid, propylene glycol as a diol and 4,4'-diphenylmethane diisocyanate as an isocyanate, with terephthalic acid/propylene glycol/4,4'-diphenylmethane diisocyanate molar ratios of 1.0/1.3/0.25 and 1.0/2.0/0.25.
The obtained polyester-urethane resin was dissolved in methyl ethyl ketone to 20 wt%. The methyl ethyl ketone solution of the polyester-urethane resin was used to coat a 80 μm-thick PET film that had been surface-treated on one side, using a coating apparatus, and it was then dried with hot air at 70°C for 10 minutes to form a film with a thickness of 35 μm, after which a macrodynamic viscoelasticity measuring apparatus was used to measure the temperature dependence of the elastic modulus with a tensile pull of 5 g and a frequency of 10 Hz. The glass transition temperatures of the obtained polyester-urethane resin were 105°C for A and 70°C for B.

(Example 1)

A binder resin was obtained by mixing and stirring 20 parts by weight of the aforementioned urethane acrylate A, 15 parts by weight of an isocyanurate-type acrylate (product name: M-325 by ToaGosei Co., Ltd.), 5 parts by weight of dimethyloltricyclodecane diacrylate (product name: DCP-A by Kyoeisha Chemical Co., Ltd.) and 3 parts by weight of 2-methacryloyloxyethyl acid phosphate (product name: P-2 M by Kyoeisha Chemical Co., Ltd.), as radical-polymerizing substances, with 4 parts by weight of benzoyl peroxide (product name: NYPER BMT-K40 by NOF Corp.) as a free radical generator and 60 parts by weight of the aforementioned 20% methyl ethyl ketone solution of polyester-urethane resin A. A nickel layer with a thickness of 0.2 $\mu$m was formed on the surfaces of particles having polystyrene nuclei, and then a 0.04 $\mu$m-thick gold layer was formed on the outside of the nickel layer, to form conductive particles with a mean particle size of 4 $\mu$m (10% compression modulus (K value): 410 Kgf/mm$^2$), which were dispersed in the aforementioned binder resin at 3 vol%. A coating apparatus was used to coat the mixture onto a 50 $\mu$m-thick PET film that had been surface-treated on one side, and the coating was dried with hot air at 70°C for 10 minutes to obtain an anisotropic conductive adhesive layer A with an adhesive layer thickness of 4 $\mu$m (width: 15 cm, length: 70 m).

Next, a binder resin was obtained by mixing and stirring 20 parts by weight of the aforementioned urethane acrylate, 20 parts by weight of bis(acryloxyethyl)isocyanurate (product name: M-325, by ToaGosei Co., Ltd.), 10 parts by weight of dimethyloltricyclodecane diacrylate (product name: DCP-A, by Kyoeisha Chemical Co., Ltd.) and 3 parts by weight of 2-methacryloyloxyethyl acid phosphate (product name: P-2M, by Kyoeisha Chemical Co., Ltd.) as radical-polymerizing substances, with 4 parts by weight of benzoyl peroxide (product name: NYPER BMT-K, by NOF Corp.) as a free radical generator, and 50 parts by weight of a 23 wt% solution of the aforementioned polyester-urethane resin B dissolved in a toluene/methyl ethyl ketone = 50/50 mixed solvent. A coating apparatus was used to coat the mixture onto a 50 $\mu$m-thick PET film that had been surface-treated on one side, and the coating was dried with hot air at 70°C for 10 minutes to obtain an adhesive layer B with a thickness of 10 $\mu$m (width: 15 cm, length: 70 m). The obtained adhesive layers A and B were attached together with their adhesives facing each other, and a laminator (RISTON Model by Dupont, HRL, roll pressure: spring weight only, roll temperature: 40°C, speed: 50 cm/min) was used for lamination. The PET film on the anisotropic conductive adhesive layer A side was released to obtain an anisotropic conductive adhesive with a thickness of 14 $\mu$m (width: 15 cm, length: 60 m).

The obtained anisotropic conductive adhesive was cut to a width of 1.5 mm and wound up to 50 m on a plastic reel with an inner diameter of 40 mm and an outer diameter of 48 mm, with the adhesive film side facing the reel surface (thickness: 1.7 mm), to obtain a tape-like circuit connecting material. Separately, the anisotropic conductive adhesive layer A and adhesive layer B formed by the coating apparatus, before lamination, were each cut to a width of 2.5 mm and wound up to 50 m on a plastic reel with an inner diameter of 40 mm and an outer diameter of 48 mm, with the adhesive film side facing the reel surface (thickness: 1.7 mm), to obtain tape-like adhesives.

(Examples 2-5)

Tape-like circuit connecting materials and tape-like adhesives were fabricated in the same manner as Example 1, except that the conductive particle sizes and adhesive layer thicknesses were changed as shown in Table 1.

(Comparative Example 1)

A tape-like circuit connecting material and tape-like adhesive were fabricated in the same manner as Example 1, except that the adhesive composition was changed as shown in Table 2, and the glass adhesive forces of the adhesive layer A and anisotropic conductive adhesive layer B were reversed.

(Comparative Example 2)

Tape-like circuit connecting materials and tape-like adhesives were fabricated in the same manner as Example 1, except that the conductive particle sizes and anisotropic conductive adhesive layer A thickness were changed as shown in Table 2, and a monolayer was used.
[Table 1]

| | Example 1 | | Example 2 | | Example 3 | | Example 4 | | Example 5 | |
|---|---|---|---|---|---|---|---|---|---|---|
| | Anisotropic conductive adhesive layer A | Adhesive layer B | Anisotropic conductive adhesive layer A | Adhesive layer B | Anisotropic conductive adhesive layer A | Adhesive layer B | Anisotropic conductive adhesive layer A | Adhesive layer B | Anisotropic conductive adhesive layer A | Adhesive layer B |
| Polyester-urethane A | 60 | 0 | 60 | 0 | 60 | 0 | 60 | 0 | 60 | 0 |
| Polyester-urethane B | 0 | 50 | 0 | 50 | 0 | 50 | 0 | 50 | 0 | 50 |
| Urethane acrylate | 20 | 20 | 20 | 20 | 20 | 20 | 20 | 20 | 20 | 20 |
| M-325 | 15 | 20 | 15 | 20 | 15 | 20 | 15 | 20 | 15 | 20 |
| DCP-A | 5 | 10 | 5 | 10 | 5 | 10 | 5 | 10 | 5 | 10 |
| P-2M | 3 | 3 | 3 | 3 | 3 | 3 | 3 | 3 | 3 | 3 |
| NYPER BMT-K | 4 | 4 | 4 | 4 | 4 | 4 | 4 | 4 | 4 | 4 |
| Conductive particle size [$\mu$m] | 4 | - | 3 | - | 5 | - | 4 | - | 4 | - |
| Adhesive thickness [$\mu$m] | 4 | 10 | 3 | 11 | 5 | 9 | 3 | 11 | 2 | 12 |

[Table 2]

|  | Comp.Ex.1 |  | Comp. Ex. 2 |
| --- | --- | --- | --- |
|  | Anisotropic conductive adhesive layer A | Adhesive layer B | Anisotropic conductive adhesive layer A |
| Polyester-urethane A | 0 | 60 | 0 |
| Polyester-urethane B | 50 | 0 | 50 |
| Urethane acrylate | 20 | 20 | 20 |
| M-325 | 20 | 15 | 20 |
| DCP-A | 10 | 5 | 10 |
| P-2M | 3 | 3 | 3 |
| NYPERBMT-K | 4 | 4 | 4 |
| Conductive particle size [$\mu$m] | 4 | - | 4 |
| Adhesive thickness [$\mu$m] | 4 | 10 | 4 |

(Measurement of connection resistance)

The adhesive film side of each tape-like circuit connecting material obtained in the examples and comparative examples (width: 1.5 mm, length: 3 cm) was transferred onto an ITO-coated glass substrate (15 $\Omega$ sq.) with a thickness of 0.7 mm by hot pressing at 70°C, 1 MPa for 2 seconds, and then the PET film was released. Next, a flexible circuit board (FPC) with 600 tin-plated copper circuits at a pitch of 50 $\mu$m and with a thickness of 8 $\mu$m was placed on the transferred adhesive and pressed at 24°C, 0.5 MPa for 1 second for temporary attachment. The glass substrate on which the FPC had been temporarily attached with the adhesive was placed in a main contact bonding apparatus and heated and pressed at 170°C, 3 MPa for 6 seconds by heat tool from the flexible circuit board side, using 200 $\mu$m-thick silicone rubber as a cushion material, for connection across a width of 1.5 mm, to obtain a connected structure of a circuit member.

The resistance value between adjacent circuits of the FPC comprising the joint of the connected structure of a circuit member was measured using a multimeter (apparatus name: TR6845, product of Advantest Corp.). The resistance value was measured at 40 resistance points between the adjacent circuits, and the average value was calculated. The obtained results are shown in Tables 3 and 4.

(Measurement of adhesive force)

The adhesive film side of each tape-like circuit connecting material obtained in the examples and comparative examples (width: 1.5 mm, length: 3 cm) was transferred onto an ITO-coated glass substrate (15$\Omega$ sq.) with a thickness of 0.7 mm by hot pressing at 70°C, 1 MPa for 2 seconds, and then the PET film was released. Next, a flexible circuit board (FPC) with 600 tin-plated copper circuits at a pitch of 50 $\mu$m and with a thickness of 8 $\mu$m was placed on the transferred adhesive and pressed at 24°C, 0.5 MPa for 1 second for temporary attachment. The glass substrate on which the FPC had been temporarily attached with the adhesive was placed in a main contact bonding apparatus and heated and pressed at 170°C, 3 MPa for 6 seconds by heat tool from the flexible circuit board side, using 200 $\mu$m-thick silicone rubber as a cushion material, for connection across a width of 1.5 mm, to obtain a connected structure of a circuit member.

The adhesive force with 90° peeling was measured for the connected structure of a circuit member at a peel rate of 50 mm/min. The obtained results are shown in Tables 3 and 4.

(Measurement of conductive particle entrapment efficiency)

The adhesive film side of each tape-like circuit connecting material obtained in the examples and comparative examples (width: 1.5 mm, length: 3 cm) was transferred onto an Al-coated glass substrate (10$\Omega$ sq.) with a thickness of 0.7 mm by hot pressing at 70°C, 1 MPa for 2 seconds, and then the PET film was released. Next, a flexible circuit board (FPC) with 600 tin-plated copper circuits at a pitch of 50 $\mu$m and with a thickness of 8 $\mu$m was placed on the transferred adhesive and pressed at 24°C, 0.5 MPa for 1 second for temporary attachment. The glass substrate on which the FPC had been temporarily attached with the adhesive was placed in a main contact bonding apparatus and heated and pressed at 170°C, 3 MPa for 6 seconds by heat tool from the flexible circuit board side, using 200 μm-thick silicone rubber as a cushion material, for connection across a width of 1.5 mm, to obtain a connected structure of a circuit member.

The number of impressions per electrode in the connected structure of a circuit member was determined by observing 20 electrodes from the glass substrate by Nomarski differential interference observation using a BH3-MJL liquid crystal panel examining microscope by Olympus Corp., and calculating the average number. Separately, the number of conductive particles per unit area in the adhesive was measured with a BH3-MJL liquid crystal panel examining microscope by Olympus Corp.. The entrapment efficiency for conductive particles was calculated based on these results, according to the following formula.

The obtained values are shown in Tables 3 and 4.

$$\text{Conductive particle entrapment efficiency} = (\text{number of conductive particles on electrode}) \times 100/\{(\text{number of conductive particles per unit area in adhesive } [/\text{mm}^2]) \times (\text{connection area per electrode } [\text{mm}^2])\}$$

(Measurement of adhesive force on glass substrates)

The adhesive side of each of the tape-like circuit connecting material or the tape-like adhesive (anisotropic conductive adhesive layer A and adhesive layer B before lamination) obtained in the examples and comparative examples (width: 2.5 mm, length: 3 cm) was transferred onto the ITO-coated side of a fully ITO-coated glass substrate (15 Ω sq.) by hot pressing at 70°C, 1 MPa for 2 seconds. Tape by Nitto Denko Corp. (NITTO TAPE) cut to a width of 2.5 mm was attached over the transferred adhesive, and the attached tape was peeled at 90° at a peel rate of 50 mm/min for each transferred adhesive, to measure the adhesive force of the adhesive for glass. The obtained results are shown in Tables 3 and 4.

[Table 3]

| | Example 1 | | | Example 2 | | | Example 3 | | | Example 4 | | | Example 5 | | |
|---|---|---|---|---|---|---|---|---|---|---|---|---|---|---|---|
| | Example 1 | Adhesive layer A | Adhesive layer B | Example 2 | Adhesive layer A | Adhesive layer B | Example 3 | Adhesive layer A | Adhesive layer B | Example 4 | Adhesive layer A | Adhesive layer B | Example 5 | Adhesive layer A | Adhesive layer B |
| Connection resistance [Ω] | 1.1 | - | - | 1.05 | - | - | 1.2 | - | - | 1.12 | - | - | 1.13 | - | - |
| Adhesive force[N/m] | 1100 | - | - | 1125 | - | - | 1200 | - | - | 1185 | - | - | 1225 | - | - |
| Conductive particle entrapment efficiency [%] | 53 | - | - | 50 | - | - | 51 | - | - | 63 | - | - | 75 | - | - |
| Adhesive force [g/ 2.5mm] | 0.042 | 0.041 | 0.21 | 0.052 | 0.05 | 0.23 | 0.054 | 0.055 | 0.22 | 0.032 | 0.031 | 0.24 | 0.027 | 0.026 | 0.25 |

[Table 4]

| | Comp. Ex. 1 | | | Comp. Ex. 2 |
|---|---|---|---|---|
| | Comp. Ex. 1 | Adhesive layer A | Adhesive layer B | Adhesive layer A |
| Connection resistance [Ω] | 1.21 | - | - | 1.07 |
| Adhesive force [N/m] | 1021 | - | - | 12.57 |
| Conductive particle entrapment efficiency [%] | 32 | - | - | 21 |
| Adhesive force [g/2.5mm] | 0.21 | 0.22 | 0.06 | 0.21 |

According to the invention, it is possible to provide a circuit connecting material and a connected structure of a circuit member, for electrical and electronic use, that have improved entrapment efficiency for conductive particles on electrodes compared to conventional circuit connecting materials and are therefore resistant to shorting between circuits and exhibit excellent connection reliability.

**Claims**

1. A circuit connecting material which is situated between mutually opposing circuit electrodes and, upon pressing the mutually opposing circuit electrodes, electrically connects the electrodes in the pressing direction,
the circuit connecting material having a laminated construction of a conductive particle-dispersed anisotropic conductive adhesive layer and an insulating adhesive layer,
wherein the adhesive force of the insulating adhesive layer for glass substrates is greater than the adhesive force of the anisotropic conductive adhesive layer for glass substrates.

2. A circuit connecting material of claim 1, wherein the mean particle size a of the conductive particles and the thickness b of the anisotropic conductive adhesive layer satisfy the relationship represented by the following formula (1):

$a \geq b : (1)$.

3. A connected structure of a circuit member, comprising:

a first circuit member with a first connecting terminal and
a second circuit member with a second connecting terminal,
disposed with the first connecting terminal and second connecting terminal mutually opposing each other,
wherein a circuit connecting material of claim 1 or 2 is situated between the mutually opposed first connecting terminal and second connecting terminal and the stack is heated and pressed to electrically connect the first connecting terminal and second connecting terminal.

*Fig.1*

(a)

(b)

(c)

# Fig.2

| **INTERNATIONAL SEARCH REPORT** | International application No. |
|---|---|
| | PCT/JP2008/072872 |

A. CLASSIFICATION OF SUBJECT MATTER
*H05K1/14*(2006.01)i, *C09J7/00*(2006.01)i, *C09J9/02*(2006.01)i, *C09J11/04*
(2006.01)i, *C09J201/00*(2006.01)i, *H01B5/16*(2006.01)i, *H01R11/01*(2006.01)i,
*H05K3/36*(2006.01)i

According to International Patent Classification (IPC) or to both national classification and IPC

B. FIELDS SEARCHED

Minimum documentation searched (classification system followed by classification symbols)
H05K1/14, C09J7/00, C09J9/02, C09J11/04, C09J201/00, H01B5/16, H01R11/01,
H05K3/36

Documentation searched other than minimum documentation to the extent that such documents are included in the fields searched
Jitsuyo Shinan Koho 1922-1996 Jitsuyo Shinan Toroku Koho 1996-2009
Kokai Jitsuyo Shinan Koho 1971-2009 Toroku Jitsuyo Shinan Koho 1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 63-310581 A (Canon Inc.), 19 December, 1988 (19.12.88), Page 2, lower left column, line 9 to page 3, upper left column, line 6; Fig. 2 (Family: none) | 1-3 |
| X | JP 2000-332157 A (Matsushita Electric Industrial Co., Ltd.), 30 November, 2000 (30.11.00), Fig. 1 (Family: none) | 1 |
| X | JP 11-326935 A (Matsushita Electric Industrial Co., Ltd.), 26 November, 1999 (26.11.99), Fig. 1 (Family: none) | 1 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search 19 March, 2009 (19.03.09) | Date of mailing of the international search report 31 March, 2009 (31.03.09) |
|---|---|
| Name and mailing address of the ISA/ Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 59120436 A
- JP 60191228 A
- JP 1251787 A
- JP 7090237 A
- JP 51020941 A
- JP 3029207 A
- JP 4174980 A
- JP 3048197 B
- JP 3477367 B
- WO 01014484 A
- JP 2001323249 A